(19)

Europäisches
Patentamt
European
Patent Office
Office européen
des brevets

(11) **EP 4 617 689 A1**

(12) **EUROPEAN PATENT APPLICATION**
published in accordance with Art. 153(4) EPC

(43) Date of publication:
**17.09.2025 Bulletin 2025/38**

(21) Application number: **23934218.1**

(22) Date of filing: **01.11.2023**

(51) International Patent Classification (IPC):
*G01R 31/36* (2020.01)      *G01R 31/392* (2019.01)
*G01R 31/396* (2019.01)    *G01R 31/3828* (2019.01)
*G01R 31/3842* (2019.01)    *G01R 31/367* (2019.01)
*G01R 19/165* (2006.01)     *B60L 58/16* (2019.01)

(52) Cooperative Patent Classification (CPC):
Y02E 60/10

(86) International application number:
**PCT/KR2023/017320**

(87) International publication number:
**WO 2024/219571 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.04.2023  KR 20230051448**

(71) Applicant: **LG Energy Solution, Ltd.
Seoul 07335 (KR)**

(72) Inventor: **CHOI, Geon
Daejeon 34122 (KR)**

(74) Representative: **Plasseraud IP
104 Rue de Richelieu
CS92104
75080 Paris Cedex 02 (FR)**

(54) **BATTERY STATE ESTIMATION METHOD AND BATTERY SYSTEM PROVIDING SAME**

(57)      Disclosed are a battery state prediction method and a battery system providing the same, the system including: a battery including a plurality of battery cells; and a battery management system (BMS) calculating a first state of charge change amount which is a difference value between a first state of charge (SOC) and a second state of charge, the first state of charge being calculated at a predetermined first time point before a current flow between the battery and an external device starts, and the second state of charge being calculated at a second time point when the current flow ends, and calculating a second state of charge change amount which is a difference value between the first state of charge and a third state of charge, the third state of charge being calculated at a third time point after a predetermined time elapses from the second time point, wherein the BMS predicts a state of health (SOH) of the battery based on the first state of charge change amount and the second state of charge change amount.

FIG. 5

```
PREDICT PLURALITY OF STATES OF CHARGE AT FIRST TIME POINT — S100
                            ↓
PREDICT PLURALITY OF STATES OF CHARGE AT SECOND TIME POINT — S200
                            ↓
PREDICT PLURALITY OF STATES OF CHARGE AT THIRD TIME POINT — S300
                            ↓
PREDICT STATE OF HEALTH BASED ON PLURALITY OF STATES OF CHARGE — S400
```

EP 4 617 689 A1

**Description**

**[Technical Field]**

CROSS-REFERENCE TO RELATED APPLICATION

This application claims priority to and the benefit of Korean Patent Application No. 10-2023-0051448 filed in the Korean Intellectual Property Office on April 19, 2023, the entire contents of which are incorporated herein by reference.

The present disclosure relates to a method of predicting a state of health (SOH) of a battery, and a battery system providing the same.

**[Background Art]**

A battery mounted in a high-output product such as an electric vehicle or a hybrid vehicle may be required to supply a high voltage to a load, thus including a plurality of cells connected in series or parallel with each other. In an eco-friendly vehicle, a performance of the battery is directly related to a performance of the vehicle, and a role of a battery management system (BMS) that efficiently manages a battery state may thus be important.

The BMS may predict the state of charge (SOC), state of health (SOH), and state of power (SOP) of the battery (or the battery cell) based on a battery current flowing through the battery, a plurality of cell voltages of the plurality of battery cells, and a battery temperature or the like (hereinafter referred to as battery data), and diagnose the battery state based on a prediction result. When an error occurs as a diagnosis result, the BMS may transmit the diagnosis result to an upper system mounted with the battery system (e.g., an automobile, a bike, or an energy storage system (ESS)), thus managing the overall safety and performance of the upper system.

Meanwhile, it is impossible to directly measure the state of health (SOH) of the battery due to nonlinearity of the battery cells. Accordingly, the BMS may include a plurality of SOH prediction models, and each of the plurality of prediction models may predict the state of health (SOH) of the battery based on the battery data.

The state of health (SOH) of the battery may not be highly reliable because the SOH of the battery is based on a result derived from an indirect prediction method rather than a direct measurement method. To overcome this problem, research and development haven been recently in progress to predict the state of health (SOH) of the battery by applying a weight to the plurality of SOH prediction models.

However, a result more unreliable than the state of health (SOH) of the battery that is predicted based on a single prediction model may be derived when a combination of a weight application ratio and the prediction model is inappropriate. There is a need for research and development to increase reliability of a method of predicting the state of health (SOH) of the battery by applying a weight to the plurality of SOH prediction model.

**[Disclosure]**

**[Technical Problem]**

The present disclosure attempts to provide a highly-reliable battery state prediction method of predicting a state of health (SOH) of a battery, and a battery system providing the same.

**[Technical Solution]**

According to an embodiment, a battery system includes: a battery including a plurality of battery cells; and a battery management system (BMS) calculating a first state of charge change amount which is a difference value between a first state of charge (SOC) and a second state of charge, the first state of charge being calculated at a predetermined first time point before a current flow between the battery and an external device starts, and the second state of charge being calculated at a second time point when the current flow ends, and calculating a second state of charge change amount which is a difference value between the first state of charge and a third state of charge, the third state of charge being calculated at a third time point after a predetermined time elapses from the second time point, wherein the BMS predicts a state of health (SOH) of the battery based on the first state of charge change amount and the second state of charge change amount.

The BMS may calculate the first state of charge change amount based on a predetermined first algorithm for predicting the state of charge of the battery, and calculate the second state of charge change amount based on the first algorithm and a predetermined second algorithm for predicting the state of charge of the battery.

The BMS may calculate a first value by applying a first weight to a third state of charge change amount corresponding to a difference value between the first state of charge and the third state of charge, calculated based on the first algorithm, calculate a second value by applying a second weight to a fourth state of charge change amount corresponding to a difference value between a fourth state of charge calculated at the first time point and a fifth state of charge calculated at the third time point, based on the second algorithm, and calculate the second state of charge change amount by adding the first value and the second value to each other.

The BMS may predict the state of health of the battery based on the following equation:

$$SOH = \frac{SOC1\_a - SOC1\_b}{\alpha \cdot (SOC1\_a - SOC1\_c) + \beta \cdot (SOC2\_a - SOC2\_c)}$$

(Here, SOC1_a indicates the first state of charge, SOC1_b indicates the second state of charge, SOC1_c indicates the third state of charge, SOC2_a indicates the fourth state of charge, SOC2_c indicates the fifth state of charge, $\alpha$ indicates the first weight, $\beta$ indicates the second weight)

The first algorithm may predict the state of charge of the battery based on an integrated value of a current flowing through the battery during the current flow.

The second algorithm may predict the state of charge of the battery based on a relationship between an open circuit voltage and a state of charge corresponding thereto.

The first weight and the second weight may be determined based on an upper system mounted with the battery and a value of a voltage across the battery.

According to another embodiment, a battery state prediction method includes: calculating a first state of charge (SOC) and a fourth state of charge respectively based on a predetermined first algorithm and a predetermined second algorithm for predicting a state of charge of a battery at a predetermined first time point before a current flow between the battery and an external device starts; calculating a second state of charge based on the first algorithm at a second time point when the current flow ends; calculating a third state of charge and a fifth state of charge respectively based on the first algorithm and the second algorithm at a third time point when a predetermined time elapses from the second time point; and predicting a state of health (SOH) of the battery based on a first state of charge change amount which is a difference value between the first state of charge and the second state of charge, a third state of charge change amount which is a difference value between the first state of charge and the third state of charge, and a fourth state of charge change amount which is a difference value between the fourth state of charge and the fifth state of charge.

In the predicting of the state of health of the battery, a first value may be calculated by applying a first weight to the third state of charge change amount, a second value may be calculated by applying a second weight to the fourth state of charge change amount, a second state of charge change amount may be calculated by adding the first value and the second value to each other, and the state of health of the battery may be predicted based on the first state of charge change amount and the second state of charge change amount.

The state of health of the battery may be predicted based on the following equation:

$$SOH = \frac{SOC1\_a - SOC1\_b}{\alpha \cdot (SOC1\_a - SOC1\_c) + \beta \cdot (SOC2\_a - SOC2\_c)}$$

(Here, SOC1_a indicates the first state of charge, SOC1_b indicates the second state of charge, SOC1_c indicates the third state of charge, SOC2_a indicates the fourth state of charge, SOC2_c indicates the fifth state of charge, $\alpha$ indicates the first weight, $\beta$ indicates the second weight).

The first algorithm may predict the state of charge of the battery based on an integrated value of a current flowing through the battery during the current flow.

The second algorithm may predict the state of charge of the battery based on a relationship between an open circuit voltage and a state of charge corresponding thereto.

**[Advantageous Effects]**

The present disclosure may predict the state of health (SOH) of the battery with the high reliability by applying the plurality of prediction models and the plurality of weights.

The present disclosure may increase the reliability of the predicted state of health (SOH) of the battery by calculating the prediction time point of the state of charge (SOC) of the battery, which is the basis for calculating the state of health (SOH) of the battery, based on the prediction model of the state of charge (SOC) and the battery feature.

The present disclosure may increase the reliability of the prediction result by predicting the state of health (SOH) of the battery by reflecting, to the plurality of prediction models, the weight optimized for the environment where the battery is used, that is, the upper system mounted with the battery system.

The present disclosure may increase the reliability of the prediction result by predicting the state of health (SOH) of the battery by reflecting, to the plurality of prediction models, the weight considering not only the upper system mounted with the battery system but also the current battery state (e.g., the cell voltage).

## [Description of the Drawings]

FIG. 1 is a conceptual diagram showing an upper system mounted with a battery system according to an embodiment.

FIG. 2 is a block diagram showing the battery system of FIG. 1 in detail.

FIG. 3 is a block diagram showing information stored in a storage unit of FIG. 2 in detail.

FIG. 4 is a view showing a change in a state of charge (SOC) of a battery in a discharge mode according to an embodiment.

FIG. 5 is a flowchart explaining a battery state prediction method according to another embodiment.

## [Mode for Invention]

Hereinafter, embodiments disclosed in the specification are described in detail with reference to the accompanying drawings, the same or similar components are denoted by the same or similar reference numerals, and an overlapping description thereof is omitted. Terms "module" and/or "unit" for components described in the following description are used only to make the specification easily understood. Therefore, these terms do not have meanings or roles distinguished from each other in themselves. Further, in describing the embodiments disclosed in the specification, omitted is a detailed description of a case where it is decided that the detailed description of the known art related to the present disclosure may obscure the gist. Furthermore, it is to be understood that the accompanying drawings are provided only to allow the embodiments of the present disclosure to be easily understood, and the spirit of the present disclosure is not limited by the accompanying drawings and includes all the modifications, equivalents and substitutions included in the spirit and scope of the present disclosure.

Terms including ordinal numbers such as "first", "second", and the like, may be used to describe various components. However, these components are not limited by these terms. These terms are used only to distinguish one component from another component.

It is to be understood that when one component is referred to as being "connected to" or "coupled to" another component, one component may be directly connected or coupled to another component, or may be connected or coupled to another component while having a third component interposed therebetween. On the other hand, it is to be understood that when referred to as being "directly connected to" or "directly coupled to" another element, one element may be connected or coupled to another element without a third element interposed therebetween.

It is to be further understood that terms "include" or "have" used in the specification specify the presence of features, numerals, steps, operations, components, parts mentioned in the specification, or combinations thereof, and do not preclude the presence or addition of one or more other features, numerals, steps, operations, components, parts, or combinations thereof.

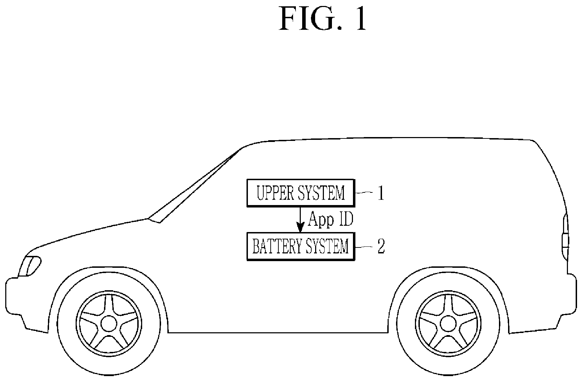

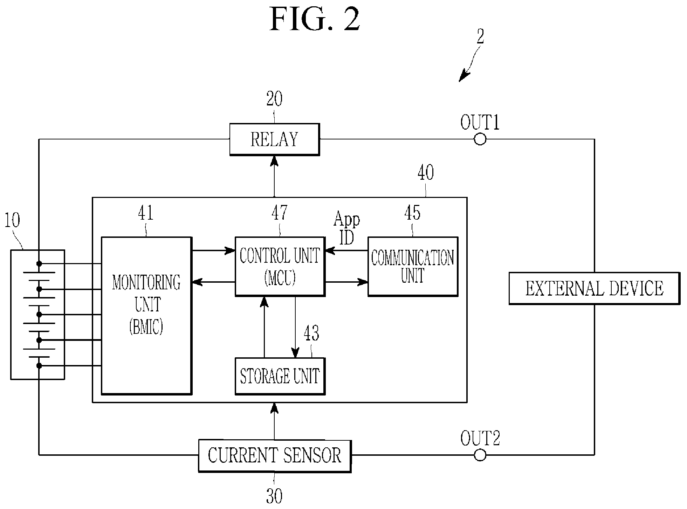

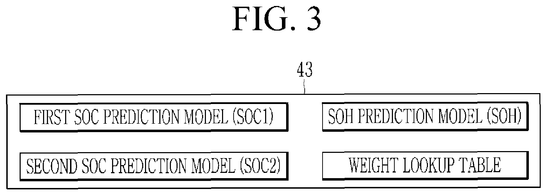

FIG. 1 is a conceptual diagram showing an upper system mounted with a battery system according to an embodiment; FIG. 2 is a block diagram showing the battery system of FIG. 1 in detail; and FIG. 3 is a block diagram showing information stored in a storage unit of FIG. 2 in detail.

Referring to FIG. 1, an upper system 1 may be mounted with a battery system 2.

The upper system 1 may include all systems each mounted with a battery. For example, the upper system 1 may include an automobile, a bike, an energy storage system (ESS), or the like.

The battery system 2 may include a customized state of X (SOX) prediction algorithm in the upper system 1. According to an embodiment, the battery system 2 may identify the upper system 1 currently mounted with the battery system 2, and predict a state of health (SOH) of the battery based on a corresponding state of health (SOH) prediction algorithm.

The battery system 2 may then predict the state of health (SOH) of the battery that may sufficiently reflect a feature of the individual upper system 1 even when a standard battery that may be used in the various upper systems 1 is mounted and used in the specific upper system 1.

Referring to FIG. 2, the battery system 2 may include a battery 10, a relay 20, a current sensor 30, and a battery management system (BMS) 40.

The battery 10 may include a plurality of battery cells electrically connected in series and parallel with each other. In some embodiments, the battery cell may be a rechargeable secondary battery. A predetermined number of battery cells may be connected in series with each other to form a battery module, a predetermined number of battery modules may be connected in series with each other to form a battery pack, and a predetermined number of battery packs may be connected in parallel with each other to form a battery bank, thereby supplying desired power. FIG. 1 shows the battery 10 in which the plurality of battery cells are connected in series with each other, the battery 10 is not limited thereto, and may be configured in a battery module unit, a battery pack unit, or a battery bank unit.

Each of the plurality of battery cells may be electrically connected to the BMS 40 through wiring. The BMS 40 may collect and analyze various information on the plurality of battery cells to thus control the charge, discharge, protection operation, or the like of the battery cell and control an operation of the relay 20.

FIG. 2 shows that the battery 10 includes the plurality of battery cells connected in series with each other, the battery 10 is connected between two output terminals OUT1 and OUT2 of the battery system 2, the relay 20 is connected between a positive electrode of the battery system 2 and the first output terminal OUT1, and the current sensor 30 is connected between a negative electrode of the battery system 2 and the second output terminal OUT2. The components and a connection relationship between the components, shown in FIG. 1, are examples, and the present disclosure is not limited thereto.

The relay 20 may control electrical connection between the battery system 2 and an external device. When the relay 20 is turned on, the battery system 2 and the external device may be electrically connected to each other to thus perform the charge or discharge of the battery, and when the relay 20 is turned off, the battery system 2 and the external device may be electrically disconnected from each other. Here, the external device may be a charger in a charge cycle in which the battery 10 receives power to thus be charged, and may be a load in a discharge cycle in which the battery 10 discharges power to the external device.

The current sensor 30 may be connected in series to a current path between the battery 10 and the external device. The current sensor 30 may measure a battery current flowing through the battery 10, that is, a charging current or a discharging current, and transmit a measurement result to the BMS 40. For example, the battery current may correspond to a cell current when the plurality of battery cells are connected in series with each other.

The BMS 40 may include a monitoring unit 41, a storage unit 43, a communication unit 45, and a control unit 47.

The monitoring unit 41 may be electrically connected to the positive and negative electrodes of each of the plurality of battery cells, and measure a cell voltage of each of the plurality of battery cells. A battery current value measured by the current sensor 30 and a battery temperature value measured by a temperature sensor (not shown) may be transmitted to the monitoring unit 41. The monitoring unit 41 may transmit information on the measured cell voltage, battery current, and battery temperature to the control unit 47.

For example, the monitoring unit 41 may measure the cell voltage of each of the plurality of battery cells at every predetermined interval during a rest period when the charging or the discharging does not occur, and calculate the cell current based on the measured cell voltage. The monitoring unit 41 may transmit the cell voltage and cell current of each of the plurality of battery cells to the control unit 47.

The storage unit 43 may store system identification information (APP ID), a weight, a plurality of prediction models predicting a battery state (or a state of X (SOX)), and battery information. The battery state (or the state of X (SOX)) may include the state of health (SOH) of the battery 10. Here, the battery information may include information related to the battery, such as the cell voltage, the cell current, the battery current, and the battery temperature.

Referring to FIG. 3, the storage unit 43 may store a plurality of SOC prediction models SOC1 and SOC2 predicting a state of charge (SOC) of the battery 10 based on the battery information by using a predetermined algorithm, at least one SOH prediction model that predicts the state of health (SOH) of the battery 10, and a weight lookup table. FIG. 3 shows a first SOC prediction model and a second SOC prediction model, that is, two SOC prediction models. However, the BMS 40 is not limited thereto, and may include three or more SOC prediction models. In addition, FIG. 3 shows one SOH prediction model. However, the BMS 40 is not limited thereto, and may include two or more SOH prediction models.

For example, the storage unit 43 may store the first SOC prediction model predicting the state of charge (SOC) based on a widely known coulomb counting method, the second SOC prediction model predicting the state of charge (SOC) based on an open circuit voltage (OCV)-SOC relationship, a third SOC prediction model predicting the state of charge (SOC) based on a terminal voltage, or the like.

For example, the storage unit 43 may store a first SOH prediction model predicting the state of health (SOH) based on the widely known OCV-SOH relationship, a second SOH prediction model predicting the state of health (SOH) based on the SOC-SOH relationship, a third SOH prediction model predicting the state of health (SOH) based on a direct current internal resistance (DCIR) of the battery cell, or the like.

The system identification information (APP ID) may be identification information for distinguishing a system mounted with the battery system 2. For example, the storage unit 43 may store various system identification information (APP ID) such as vehicle system identification information (E_Vehicle, APP ID=001), bike system identification information (E_Bike, APP ID=002), and ESS system identification information (E_ESS, APP ID=003), or the like.

The weight may be a value that is preset and stored in the storage unit 43 to predict the customized battery state (SOX) in the upper system 1. In some embodiments, the weight may include a plurality of first weights corresponding to the system identification information (APP ID). In another embodiment, the weight may include the system identification information (APP ID) and a plurality of second weights corresponding to predetermined prediction conditions. A more detailed description thereof is provided below with the control unit 47.

The prediction condition may be a condition reflecting a current state of the battery cell. For example, the prediction condition may be determined based on a result of comparing the cell voltage of the battery cell with a predetermined reference value. For another example, the prediction condition may include a condition determined by the cell voltage, battery current, or battery temperature of the battery cell. However, the prediction condition is not limited to the cell voltage, the battery current, or the battery temperature, and may include various conditions reflecting a current state of the battery 10 or that of the battery cell.

The communication unit 45 may communicate with the upper system 1 and receive identification information of the upper system 1 (hereinafter referred to as the system identification information). For example, the control unit 47 may store the system identification information (APP ID) received through the communication unit 45 in the storage unit 43.

The control unit 47 may determine the system identification information (APP ID) and a weight corresponding to at least one of the predetermined prediction conditions based on the lookup table. The control unit 47 may apply the determined weight to a plurality of prediction results predicted by the plurality of SOX prediction models, and calculate an average value by adding up the plurality of prediction results to which the weights are applied.

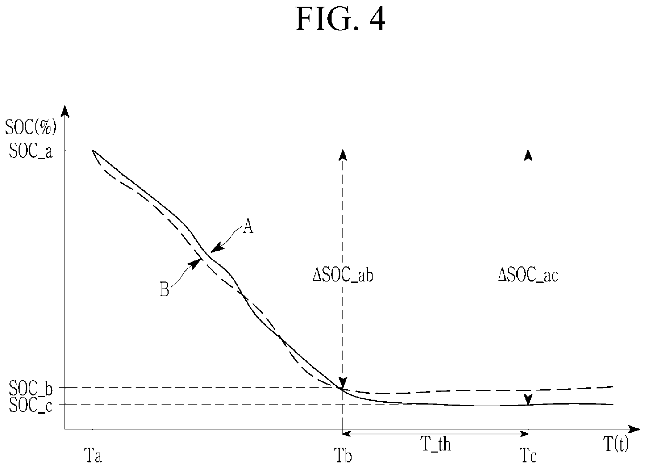

In some embodiments, the control unit 47 may calculate the state of health (SOH) of the battery 10 based on an average value of a plurality of SOC values to which the weights are applied. Hereinafter, a specific calculation method of the state of health (SOH) is described with reference to FIG. 4.

Table 1 below shows an example of the plurality of first weights corresponding to certain system identification information (APP ID). As described above, the first weight may be a weight that only considers the system identification information (APP ID), and a corresponding value may be different for each prediction model, as shown in Table 1 below.

[Table 1]

| Identification information / Prediction model | APP ID = 001 (E_Vehicle) | APP ID = 002 (E_Bike) |
|---|---|---|
| 1st SOC Prediction model | 0.7 | 0.85 |
| 2nd SOC Prediction model | 0.3 | 0.15 |

For example, referring to Table 1, assume that the upper system 1 is the vehicle system (E_Vehicle, APP ID=001). The control unit 47 may calculate an average value of the state of charge (SOC) of the battery 10 by applying the first weight of 0.7 corresponding to a first SOC value predicted by the first SOC prediction model, and applying the first weight of 0.3 corresponding to a second SOC value predicted by the second SOC prediction model.

In detail, the first SOC value predicted by the first SOC prediction model may be 50%, and the second SOC value predicted by the second SOC prediction model may be 54%. In this case, the control unit 47 may calculate the average value of the state of charge (SOC) as 51.2% (50% $\times$ 0.7 + 54% $\times$ 0.3 = 51.2%).

Table 2 below shows an example of the plurality of second weights corresponding to certain system identification information (APP ID) and prediction condition. As described above, the second weight may be a weight that considers both the system identification information (APP ID) and the prediction condition, and a corresponding value may be different for each prediction model, as shown in Table 2 below.

[Table 2]

| Identification information / Prediction condition | | APP ID = 001 (E_Vehicle) | APP ID = 002 (E_Bike) |
|---|---|---|---|
| Cell voltage of 3.7 V or more | 1st SOC Prediction model | 0.7 | 0.85 |
| | 2nd SOC Prediction model | 0.3 | 0.15 |
| Cell voltage less than 3.7 V | 1st SOC Prediction model | 0.3 | 0.5 |
| | 2nd SOC Prediction model | 0.7 | 0.5 |

Table 2 shows that the prediction condition is the condition determined based on the result of comparing the cell voltage and the predetermined reference value (e.g., 3.7V) with each other. However, as described above, the prediction condition is not limited to the cell voltage or the reference value, and may be equally applied to a unit of the battery 10. Here, the cell voltage may indicate an average value of the cell voltage of each of the plurality of battery cells included in the battery module, is not limited thereto, and may indicate the median or average value of the plurality of cell voltages.

For example, referring to Table 2, assume that the upper system 1 is the vehicle system (E_Vehicle, APP ID=001), and the cell voltage of the battery cell currently included in the battery 10 is 3.7 V or more. Referring to Table 2, the control unit 47 may calculate the average value of the state of charge (SOC) of the battery cell or that of the battery 10 by applying the second weight of 0.7 corresponding to the first SOC value predicted by the first SOC prediction model, and applying the second weight of 0.3 corresponding to the second SOC value predicted by the second SOC prediction model.

In detail, the first SOC value predicted by the first SOC prediction model may be 50%, and the second SOC value predicted by the second SOC prediction model may be 54%. In this case, the control unit 47 may calculate the average value of the state of charge (SOC) of the battery cell or that of the battery 10 as 51.2% ($50\% \times 0.7 + 54\% \times 0.3 = 51.2\%$).

For another example, referring to Table 2, assume that the upper system 1 is the bike system (E_Bike, APP ID=002), and the cell voltage of the battery cell currently included in the battery 10 is less than 3.7 V. Referring to Table 2, the control unit 47 may calculate the average value of the state of charge (SOC) of the battery cell or that of the battery 10 by applying the second weight of 0.5 corresponding to the first SOC value predicted by the first SOC prediction model, and applying the second weight of 0.5 corresponding to the second SOC value predicted by the second SOC prediction model.

In detail, the first SOC value predicted by the first SOC prediction model may be 50%, and the second SOC value predicted by the second SOC prediction model may be 54%. In this case, the control unit 47 may calculate the average value of the state of charge (SOC) of the battery cell or that of the battery 10 as 52% ($50\% \times 0.5 + 54\% \times 0.5 = 52\%$).

Referring to FIG. 3, Table 1 and Table 2 may be examples of the weight lookup table. However, the weight lookup table is not limited thereto, and may be written in various formats. Tables 1 and 2 above only describe the state of charge (SOC) of the battery 10, and are not limited thereto. In some embodiments, the control unit 47 may predict the state of health (SOH) of the battery 10 based on the average value of the state of charge (SOC) of the battery 10 that is calculated by the method described above. Hereinafter, the method of the control unit 47 predicting the state of health (SOH) of the battery 10 is described in detail with reference to FIG. 4.

FIG. 4 is a view showing a change in the state of charge (SOC) of the battery in a discharge mode according to an embodiment.

FIG. 4 is a graph showing the change in the state of charge (SOC) of the battery 10 over time in the discharge mode where the battery 10 supplies power to the external device. A first graph A may be a graph showing the change in the state of charge (SOC) of the battery 10 that is predicted using only one algorithm. A second graph B may be a graph showing the change in the state of charge (SOC) of the battery 10 that is predicted using a plurality of algorithms.

For example, the second graph B may be a graph that better reflects the current state of the battery 10 than the first graph A. FIG. 4 shows the first graph A with a solid line and the second graph B with a dotted line. Hereinafter, a method of calculating the state of health (SOH) of the battery 10 is described based on the first graph A in some embodiments.

A first time point Ta may be a time point when a current flow of the battery 10 starts or a predetermined time point in a period before the current flow starts. A second time point Tb may be a time point when the current flow of the battery 10 ends. A third time point Tc may be a time point when a predetermined standby time T_th elapses from the second time point Tb.

The standby time T_th may be experimentally determined for various reasons such as an algorithm for predicting the state of charge (SOC) and/or the feature of the battery 10. For example, in order to measure an accurate open circuit voltage (OCV), it is necessary to measure the OCV after a predetermined time elapses after the current flow of the battery 10 ends, and the state of the battery 10 is thus stabilized. Referring to FIG. 4, when including the algorithm for predicting the state of charge (SOC) based on the OCV, the SOC prediction model may predict the state of charge (SOC) based on the open circuit voltage (OCV) measured at the third time point Tc when the predetermined time elapses after the current flow of the battery 10 ends. In this case, the SOC prediction model may predict the state of charge (SOC) with higher precision compared to a case of predicting the state of charge (SOC) based on the open circuit voltage (OCV) measured at the second time point Tb when the current flow of the battery 10 ends. In some embodiments, the standby time T_th may be set by considering a time it takes to stabilize the battery 10 after the current flow ends based on a type of the battery 10.

The control unit 47 may calculate the state of health (SOH) of the battery 10 based on Equations 1 to 3 below. For example, the control unit 47 may calculate the state of health (SOH) of the battery 10 based on the algorithm (or the SOH prediction model) corresponding to Equations 1 to 3 below.

$$SOH = \frac{\triangle SOC\_ab}{\triangle SOC\_ac}$$

- equation 1

$$SOH = \frac{\triangle SOC1\_ab}{\alpha \cdot (\triangle SOC1\_ac) + \beta \cdot (\triangle SOC2\_ac)}$$

- equation 2

$$SOH = \frac{SOC1\_a - SOC1\_b}{\alpha \cdot (SOC1\_a - SOC1\_c) + \beta \cdot (SOC2\_a - SOC2\_c)}$$

- equation 3

Referring to Equation 1, a first state of charge change amount $\triangle SOC\_ab$ may be a state of charge change amount of the battery 10 during a period from the first time point Ta to the second time point Tb. A second state of charge change amount $\triangle SOC\_ac$ may be a state of charge change amount of the battery 10 during a period from the first time point Ta to the third time point Tc. Referring to Equation 1, the control unit 47 may calculate the state of health (SOH) of the battery 10 based on a ratio of the first state of charge change amount $\triangle SOC\_ab$ to the second state of charge change amount $\triangle SOC\_ac$.

Equation 2 may be a more detailed expression of Equation 1. Equation 3 may be a more detailed expression of Equation 2. Referring to Equation 2 and Equation 3, a state of charge SOC1 may be the state of charge (SOC) calculated based on the first SOC prediction model. A state of charge SOC2 may be the state of charge (SOC) calculated based on the second SOC prediction model.

In some embodiments, the first SOC prediction model may be an algorithm for predicting the state of charge (SOC) based on the coulomb counting method. The coulomb counting method may be an algorithm for predicting the state of charge (OSC) of the battery 10 based on an integrated value of the current flowing through the battery 10 during the current flow. For example, the coulomb counting method may correspond to Equation 4 below.

$$SOC(t) = SOC(0) - \int_0^t \frac{I(t)}{C_n} \, dt$$

- equation 4

Equation 4 shows that SOC(t) is the state of charge (SOC) at a predetermined time t, SOC(0) is an initial state of charge (at t=zero), C is a rated capacity of the battery 10, and I is the battery current flowing through the battery 10 during a current flow process. However, the first SOC prediction model is not limited to Equation 4, and may include various existing algorithms for predicting the state of charge (SOC) of the battery 10 by accumulating the battery current flowing through the battery 10 during a charge or discharge process.

The second SOC prediction model may be an algorithm for predicting the state of charge (SOC) based on an "OCV-SOC relationship table" or an "OCV-SOC relationship graph" that shows a relationship between the state of charge (SOC) and the open circuit voltage (OCV) corresponding thereto. For example, the OCV-SOC relationship graph is a graph showing the state of charge (SOC) on its horizontal axis and the open circuit voltage (OCV) on its vertical axis, and may be calculated by an experiment. A corresponding state of charge (SOC) may be easily confirmed when acquiring a predetermined open circuit voltage (OCV) value.

Referring to Equation 2, Equation 3, and FIG. 4, the control unit 47 may calculate a first state of charge change amount $\triangle SOC1\_ab$. In detail, the control unit 47 may calculate a first state of charge $SOC1\_a$ corresponding to the first time point Ta based on the first SOC prediction model and a second state of charge $SOC1\_b$ corresponding to the second time point Tb based on the first SOC prediction model. The control unit 47 may calculate the first state of charge change amount $\triangle SOC1\_ab$ corresponding to a difference value between the first state of charge $SOC1\_a$ and the second state of charge $SOC1\_b$.

The first state of charge change amount $\triangle SOC1\_ab$ may be the state of charge change amount of the battery 10 that is calculated during the period from the first time point Ta to the second time point Tb based on the first SOC prediction model. In addition, referring to Equation 1 and Equation 2, the first state of charge change amount $\triangle SOC\_ab$ may correspond to the first state of charge change amount $\triangle SOC1\_ab$.

The control unit 47 may calculate a third state of charge change amount $\triangle SOC1\_ac$. In detail, the control unit 47 may calculate a third state of charge $SOC1\_c$ corresponding to the third time point Tc based on the first SOC prediction model. The control unit 47 may calculate the third state of charge change amount $\triangle SOC1\_ac$ corresponding to a difference value between the first state of charge $SOC1\_a$ and the third state of charge $SOC1\_c$.

The control unit 47 may calculate a fourth state of charge change amount $\triangle SOC2\_ac$. In detail, the control unit 47 may calculate a fourth state of charge $SOC2\_a$ corresponding to the first time point Ta based on the second SOC prediction model. The control unit 47 may calculate a fifth state of charge $SOC2\_c$ corresponding to the third time point Tc based on the second SOC prediction model. The control unit 47 may calculate the fourth state of charge change amount $\triangle SOC2\_ac$ corresponding to a difference value between the fourth state of charge $SOC2\_a$ and the fifth state of charge $SOC2\_c$.

The control unit 47 may calculate a first denominator value $\alpha(\triangle SOC1\_ac)$ by applying a first weight $\alpha$ to the third state of charge change amount $\triangle SOC1\_ac$. The control unit 47 may calculate a second denominator value $\beta(\triangle SOC2\_ac)$ by applying a second weight $\beta$ to the fourth state of charge change amount $\triangle SOC2\_ac$. The control unit 47 may calculate a fifth state of charge change amount $\alpha(\triangle SOC1\_ac)+\beta(\triangle SOC2\_ac)$ by adding the first denominator value $\alpha(\triangle SOC1\_ac)$ and the second denominator value $\beta(\triangle SOC2\_ac)$.

The fifth state of charge change amount $\alpha(\triangle SOC1\_ac)+\beta(\triangle SOC2\_ac)$ may correspond to the state of charge change amount of the battery 10 that is calculated during the period from the first time point Ta to the third time point Tc based on the first SOC prediction model and the second SOC prediction model. In addition, referring to Equation 1 and Equation 3, the second state of charge change amount $\triangle SOC\_ac$ may correspond to the fifth state of charge change amount $\alpha(\triangle SOC1\_ac)+\beta(\triangle SOC2\_ac)$.

The control unit 47 may calculate the state of health (SOH) of the battery 10 based on a ratio of the first state of charge change amount $\triangle SOC\_ab$ to the fifth state of charge change amount $\alpha(\triangle SOC1\_ac)+\beta(\triangle SOC2\_ac)$.

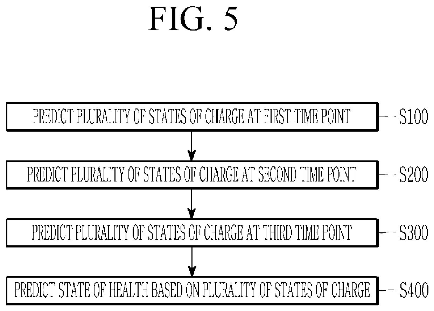

FIG. 5 is a flowchart explaining a battery state prediction method according to another embodiment.

Referring to FIGS. 4 and 5, a battery management system (BMS) 40 may calculate a first state of charge $SOC1\_a$ and a fourth state of charge $SOC2\_a$ respectively based on a predetermined first algorithm and a predetermined second algorithm for predicting a state of charge (SOC) of a battery 10 at a predetermined first time point Ta before a current flow between the battery 10 and an external device starts (S100).

In some embodiments, the first algorithm may be an algorithm corresponding to a coulomb counting method of predicting the state of charge of the battery 10 based on an integrated value of a current flowing through the battery 10 during the current flow. For example, the coulomb counting method may correspond to Equation 4 above.

In some embodiments, the first algorithm may be an algorithm for predicting the state of charge of the battery 10 based on an 'open circuit voltage (OCV)-state of charge (SOC) relationship table' or an 'OCV-SOC relationship graph' that shows a relationship between the state of charge (SOC) and the open circuit voltage (OCV) corresponding thereto.

Next, the BMS 40 may calculate a second state of charge $SOC1\_b$ based on the first algorithm at a second time point Tb when the current flow ends (S200).

Next, the BMS 40 may calculate a third state of charge $SOC1\_c$ and a fifth state of charge $SOC2\_c$ respectively based on the first algorithm and the second algorithm at a third time point Tc when a predetermined time elapses from the second time point Tb (S300).

The third time point Tc may be a time point when a predetermined standby time T_th elapses from the second time point Tb. The standby time T_th may be experimentally determined for various reasons such as an algorithm for predicting the state of charge (SOC) and/or a feature of the battery 10. For example, in order to measure an accurate open circuit voltage (OCV), it is necessary to measure the OCV after a predetermined time elapses after the current flow of the battery 10 ends, and the state of the battery 10 is thus stabilized. Referring to FIG. 4, when including the algorithm for predicting the state of charge (SOC) based on the OCV, the SOC prediction model may predict the state of charge (SOC) based on the open circuit voltage (OCV) measured at the third time point Tc when the predetermined time elapses after the current flow of the battery 10 ends. In this case, the SOC prediction model may predict the state of charge (SOC) with higher precision compared to a case of predicting the state of charge (SOC) based on the open circuit voltage (OCV) measured at the second time point Tb when the current flow of the battery 10 ends. In some embodiments, the standby time T_th may be set by considering a time it takes to stabilize the battery 10 after the current flow ends based on a type of the battery 10.

Next, the BMS 40 may predict a state of health (SOH) of the battery based on first to fifth state of charges SOC1_a, SOC1_b, SOC1_c, SOC2_a, and SOC2_c (S400).

The BMS 40 may calculate a first state of charge change amount △SOC_ab which is a difference value between the first state of charge SOC1_a and the second state of charge SOC1_b. In detail, referring to Equation 1 above, the first state of charge change amount △SOC_ab may be a state of charge change amount of the battery 10 that is predicted based on the first algorithm during a period from the first time point Ta to the second time point Tb.

The BMS 40 may calculate a third state of charge change amount △SOC1_ac which is a difference value between the first state of charge SOC1_a and the third state of charge SOC1_c. In detail, referring to Equation 2 above, the third state of charge change amount △SOC1_ac may be the state of charge change amount of the battery 10 that is predicted based on the first algorithm during a period from the first time point Ta to the third time point Tc.

The BMS 40 may calculate a fourth state of charge change amount △SOC2_ac which is a difference value between the fourth state of charge SOC2_a and the fifth state of charge SOC2_c. In detail, referring to Equation 2 above, the fourth state of charge change amount △SOC2_ac may be the state of charge change amount of the battery 10 that is predicted based on the second algorithm during the period from the first time point Ta to the third time point Tc.

The BMS 40 may calculate a second state of charge change amount △SOC_ac based on the third state of charge change amount △SOC1_ac and the fourth state of charge change amount △SOC2_ac. Referring to Equation 2, equation 3, and FIG. 4, the second state of charge change amount △SOC_ac may be the state of charge change amount of the battery 10 that is predicted based on the first algorithm and the second algorithm during the period from the first time point Ta to the third time point Tc.

In detail, the BMS 40 may calculate a first value $\alpha(\triangle SOC1\_ac)$ by applying a first weight $\alpha$ to the third state of charge change amount △SOC1_ac, and calculate a second value $\beta(\triangle SOC2\_ac)$ by applying a second weight $\beta$ to the fourth state of charge change amount △SOC2_ac. The BMS 40 may calculate the second state of charge change amount △SOC_ac by adding a first value and a second value to each other.

The BMS 40 may predict the state of health (SOH) of the battery 10 based on the first state of charge change amount △SOC_ab and second state of charge change amount △SOC_ac. Referring to Equation 1, the BMS 40 may predict the state of health (SOH) of the battery 10 based on a ratio of the first state of charge change amount △SOC_ab to the second state of charge change amount △SOC_ac.

Although the embodiments of the present disclosure have been described in detail hereinabove, the scope of the present disclosure is not limited thereto. Various modifications and improvements made by those skilled in the art to which the present disclosure pertains also belong to the scope of the present disclosure.

**Claims**

1. A battery system comprising:

    a battery including a plurality of battery cells; and
    a battery management system (BMS) calculating a first state of charge change amount which is a difference value between a first state of charge (SOC) and a second state of charge, the first state of charge being calculated at a predetermined first time point before a current flow between the battery and an external device starts, and the second state of charge being calculated at a second time point when the current flow ends, and calculating a second state of charge change amount which is a difference value between the first state of charge and a third state of charge, the third state of charge being calculated at a third time point after a predetermined time elapses from the second time point,
    wherein the BMS predicts
    a state of health (SOH) of the battery based on the first state of charge change amount and the second state of charge change amount.

2. The system of claim 1, wherein

    the BMS calculates
    the first state of charge change amount based on a predetermined first algorithm for predicting the state of charge of the battery, and calculates the second state of charge change amount based on the first algorithm and a predetermined second algorithm for predicting the state of charge of the battery.

3. The system of claim 2, wherein

the BMS calculates
a first value by applying a first weight to a third state of charge change amount corresponding to a difference value between the first state of charge and the third state of charge, calculated based on the first algorithm, calculates a second value by applying a second weight to a fourth state of charge change amount corresponding to a difference value between a fourth state of charge calculated at the first time point and a fifth state of charge calculated at the third time point, based on the second algorithm, and calculates the second state of charge change amount by adding the first value and the second value to each other.

4. The system of claim 3, wherein

the BMS predicts
the state of health of the battery based on the following equation:

$$SOH = \frac{SOC1\_a - SOC1\_b}{\alpha \cdot (SOC1\_a - SOC1\_c) + \beta \cdot (SOC2\_a - SOC2\_c)}$$

(Here, SOC1_a indicates the first state of charge, SOC1_b indicates the second state of charge, SOC1_c indicates the third state of charge, SOC2_a indicates the fourth state of charge, SOC2_c indicates the fifth state of charge, $\alpha$ indicates the first weight, $\beta$ indicates the second weight).

5. The system of claim 3, wherein

the first algorithm predicts
the state of charge of the battery based on an integrated value of a current flowing through the battery during the current flow.

6. The system of claim 3, wherein

the second algorithm predicts
the state of charge of the battery based on a relationship between an open circuit voltage and a state of charge corresponding thereto.

7. The system of claim 3, wherein

the first weight and the second weight are
determined based on an upper system mounted with the battery and a value of a voltage across the battery.

8. A battery state prediction method comprising:

calculating a first state of charge (SOC) and a fourth state of charge respectively based on a predetermined first algorithm and a predetermined second algorithm for predicting a state of charge of a battery at a predetermined first time point before a current flow between the battery and an external device starts;
calculating a second state of charge based on the first algorithm at a second time point when the current flow ends;
calculating a third state of charge and a fifth state of charge respectively based on the first algorithm and the second algorithm at a third time point when a predetermined time elapses from the second time point; and
predicting a state of health (SOH) of the battery based on a first state of charge change amount which is a difference value between the first state of charge and the second state of charge, a third state of charge change amount which is a difference value between the first state of charge and the third state of charge, and a fourth state of charge change amount which is a difference value between the fourth state of charge and the fifth state of charge.

9. The method of claim 8, wherein

in the predicting of the state of health of the battery,

a first value is calculated by applying a first weight to the third state of charge change amount, a second value is calculated by applying a second weight to the fourth state of charge change amount, a second state of charge change amount is calculated by adding the first value and the second value to each other, and the state of health of the battery is predicted based on the first state of charge change amount and the second state of charge change amount.

10. The method of claim 9, wherein

in the predicting of the state of health of the battery,
the state of health of the battery is predicted based on the following equation:

$$SOH = \frac{SOC1\_a - SOC1\_b}{\alpha \cdot (SOC1\_a - SOC1\_c) + \beta \cdot (SOC2\_a - SOC2\_c)}$$

(Here, SOC1_a indicates the first state of charge, SOC1_b indicates the second state of charge, SOC1_c indicates the third state of charge, SOC2_a indicates the fourth state of charge, SOC2_c indicates the fifth state of charge, $\alpha$ indicates the first weight, $\beta$ indicates the second weight).

11. The method of claim 8, wherein

the first algorithm predicts
the state of charge of the battery based on an integrated value of a current flowing through the battery during the current flow.

12. The method of claim 8, wherein

the second algorithm predicts
the state of charge of the battery based on a relationship between an open circuit voltage and a state of charge corresponding thereto.

# FIG. 1

UPPER SYSTEM — 1

App ID

BATTERY SYSTEM — 2

EP 4 617 689 A1

# FIG. 2

EP 4 617 689 A1

# FIG. 3

43

| FIRST SOC PREDICTION MODEL (SOC1) | SOH PREDICTION MODEL (SOH) |
|---|---|
| SECOND SOC PREDICTION MODEL (SOC2) | WEIGHT LOOKUP TABLE |

FIG. 4

EP 4 617 689 A1

# FIG. 5

| | |
|---|---|
| PREDICT PLURALITY OF STATES OF CHARGE AT FIRST TIME POINT | — S100 |
| PREDICT PLURALITY OF STATES OF CHARGE AT SECOND TIME POINT | — S200 |
| PREDICT PLURALITY OF STATES OF CHARGE AT THIRD TIME POINT | — S300 |
| PREDICT STATE OF HEALTH BASED ON PLURALITY OF STATES OF CHARGE | — S400 |

## INTERNATIONAL SEARCH REPORT

| International application No. |
| --- |
| **PCT/KR2023/017320** |

| A. | CLASSIFICATION OF SUBJECT MATTER |
| --- | --- |

**G01R 31/36**(2006.01)i; **G01R 31/392**(2019.01)i; **G01R 31/396**(2019.01)i; **G01R 31/3828**(2019.01)i;
**G01R 31/3842**(2019.01)i; **G01R 31/367**(2019.01)i; **G01R 19/165**(2006.01)i; **B60L 58/16**(2019.01)i

According to International Patent Classification (IPC) or to both national classification and IPC

| B. | FIELDS SEARCHED |
| --- | --- |

Minimum documentation searched (classification system followed by classification symbols)

G01R 31/36(2006.01); G01R 31/367(2019.01); G01R 31/374(2019.01); G01R 31/382(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전상태(SOC, State of Charge), BMS(Battery Management System), SOH(State of Health), 개방회로전압(OCV, Open Circuit Voltage)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2022-0168920 A (LG ENERGY SOLUTION, LTD.) 26 December 2022 (2022-12-26) See paragraphs [0006]-[0068], [0091] and [0107]; and figures 1-8. | 1-2,8 |
| Y | | 11-12 |
| A | | 3-7,9-10 |
| Y | KR 10-2020-0038914 A (LG CHEM, LTD.) 14 April 2020 (2020-04-14) See paragraphs [0007]-[0012]. | 11-12 |
| A | KR 10-2010-0019249 A (LG CHEM, LTD.) 18 February 2010 (2010-02-18) See paragraphs [0027]-[0143]; and figures 1-10. | 1-12 |
| A | KR 10-2011-0084633 A (SK INNOVATION CO., LTD.) 26 July 2011 (2011-07-26) See paragraphs [0019]-[0076]; and figures 1-5. | 1-12 |

☑ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **05 February 2024** | **05 February 2024** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
|---|
| **PCT/KR2023/017320** |

### C.     DOCUMENTS CONSIDERED TO BE RELEVANT

| Category* | Citation of document, with indication, where appropriate, of the relevant passages | Relevant to claim No. |
|---|---|---|
| A | KR 10-2016-0011172 A (RICHTEK TECHNOLOGY CORP.) 29 January 2016 (2016-01-29)<br>See paragraphs [0006]-[0038]; and figures 1-14. | 1-12 |

Form PCT/ISA/210 (second sheet) (July 2022)

**INTERNATIONAL SEARCH REPORT**
Information on patent family members

International application No.

**PCT/KR2023/017320**

| Patent document cited in search report | | | Publication date (day/month/year) | Patent family member(s) | | | Publication date (day/month/year) |
|---|---|---|---|---|---|---|---|
| KR | 10-2022-0168920 | A | 26 December 2022 | CN | 116264842 | A | 16 June 2023 |
| | | | | EP | 4198537 | A1 | 21 June 2023 |
| | | | | JP | 2023-541955 | A | 04 October 2023 |
| | | | | WO | 2022-265357 | A1 | 22 December 2022 |
| KR | 10-2020-0038914 | A | 14 April 2020 | KR | 10-2101912 | B1 | 17 April 2020 |
| | | | | KR | 10-2205318 | B1 | 20 January 2021 |
| | | | | US | 11112461 | B2 | 07 September 2021 |
| | | | | US | 2020-0003844 | A1 | 02 January 2020 |
| | | | | WO | 2018-151431 | A1 | 23 August 2018 |
| KR | 10-2010-0019249 | A | 18 February 2010 | CN | 102119338 | A | 06 July 2011 |
| | | | | CN | 102119338 | B | 21 August 2013 |
| | | | | EP | 2321663 | A1 | 18 May 2011 |
| | | | | EP | 2321663 | B1 | 27 May 2015 |
| | | | | JP | 2011-530696 | A | 22 December 2011 |
| | | | | JP | 5269994 | B2 | 21 August 2013 |
| | | | | KR | 10-0970841 | B1 | 16 July 2010 |
| | | | | US | 08046181 | B2 | 25 October 2011 |
| | | | | US | 08332169 | B2 | 11 December 2012 |
| | | | | US | 2010-0036626 | A1 | 11 February 2010 |
| | | | | US | 2012-0035873 | A1 | 09 February 2012 |
| | | | | WO | 2010-016647 | A1 | 11 February 2010 |
| KR | 10-2011-0084633 | A | 26 July 2011 | KR | 10-1399388 | B1 | 27 May 2014 |
| KR | 10-2016-0011172 | A | 29 January 2016 | CN | 105277894 | A | 27 January 2016 |
| | | | | CN | 105277894 | B | 05 January 2018 |
| | | | | KR | 10-1802028 | B1 | 27 November 2017 |
| | | | | US | 10823785 | B2 | 03 November 2020 |
| | | | | US | 2016-0018468 | A1 | 21 January 2016 |
| | | | | US | 2016-0018469 | A1 | 21 January 2016 |
| | | | | US | 2017-343610 | A1 | 30 November 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230051448